# EUROPEAN PATENT SPECIFICATION

(11) **EP 2 080 817 B1**
(45) Date of publication and mention of the grant of the patent: **15.06.2011**
(21) Application number: 08171764.7
(22) Date of filing: 16.12.2008
(51) Int. Cl.: C23C 16/44, H01J 37/32

(54) **Method and apparatus for chamber cleaning by in-situ plasma excitation**
Verfahren und Vorrichtung zur Kammerreinigung durch In-situ-Plasmaanregung
Procédé et appareil pour le nettoyage de chambre par excitation du plasma in situ

(30) Priority: 19.12.2007 US 960442
(43) Date of publication of application: 22.07.2009
(73) Proprietor: INTEVAC, INC., Santa Clara, California 95054 (US)
(72) Inventor: Huang, Judy, Los Gatos, CA 95030 (US); Barnes, Michael S., San Ramon, CA 94583 (US); Bluck, Terry, Santa Clara, CA 95051 (US)
(74) Representative: Borchert, Uwe Rudolf

(56) References cited:
- EP-A- 0 930 642
- EP-A- 1 401 014
- WO-A-99/02754
- US-A1- 2003 029 475

## Description

The general field of the invention relates to a unique method and apparatus for plasma chamber cleaning by in-situ plasma excitation.

Various processing chambers, such as, e.g., vacuum chambers for semiconductor, flat panel, solar panel, etc., fabrication, require periodic cleaning. Such cleaning is conventionally done using plasma excitation. In the current art, there are two relevant known method for such cleaning, which are generally referred to as: remote plasma clean and in-situ plasma clean. Normally, the generation of plasma for cleaning purposes differes from the generation of plasma for the fabrication process. One driver for the difference is the need to avoid the chambers walls and chuck from being attacked by the plasma. Therefore, the design of the plasma cleaning operation requires the creation of "soft plasma."

One well known method for generating "soft plasma" for cleaning purposes is the above-mentioned remote plasma clean system. In remote plasma clean system the plasma is generated remotely from the processing space that needs to be cleaned, and the generated radicals are allowed to float or migrate into the processing space for cleaning purposes. On the other hand, chambers employing in-situ chamber clean simply maintain the cleaning plasma under different conditions than the processing plasma. For example, source power may be reduced, and no bias power may be applied, so as to avoid accelerating radicals in the plasma.

One class of processing chambers requiring the above periodical cleaning is chemical vapor deposition (CVD) chambers. While some forms of plasma assisted or plasma enhanced CVD chambers are utilized, conventional CVD chambers do not utilize plasma for the CVD process. Consequently, such CVD chambers do not have plasma generation capability, other than for cleaning purposes. Therefore, conventional CVD chambers utilize the remote plasma clean method, for example, remote microwave plasma clean.

The WO 99/2754 discloses a method and an apparatus for cleaning a chamber in a substrate processing system having less reactivity with the chamber walls and the components contained therein. The method includes mixing a diluent gas with a flow of radicals produced by a plasma remotely disposed with respect to the chamber, at a point located between a plasma applicator and the chamber. The apparatus includes a fluid manifold having multiple inlets and an outlet with the outlet being coupled to an intake port of the chamber. One of the inlets are in fluid communication with the plasma applicator, with the remaining inlets being in fluid communication with a supply of the diluent gas. In this fashion, the diluent gas flow and the flow of reactive radicals mix when traveling between the inlets and the outlet to form a gas-radical mixture egressing from the outlet and traversing through the intake port.

According to EP 1 401 014 a plasma treatment apparatus has a reaction vessel provided with a top electrode and a bottom electrode, and the first electrode is supplied with a VHF band high frequency power from a VHF band high frequency power source, while the bottom electrode on which a substrate is loaded and is moved by a vertical movement mechanism. The plasma treatment system has a controller which, at the time of a cleaning process after forming a film on the substrate, controls a vertical movement mechanism to move the bottom electrode to narrow the gap between the top electrode and bottom electrode and form a narrow space and starts cleaning by a predetermined high density plasma in that narrow space. In the cleaning process, step cleaning is performed. Due to this, the efficiency of utilization of the cleaning gas is increased, the amount of exhaust gas is cut, and the cleaning speed is raised. Further, the amount of the process gas used is cut and the process cost is reduced.

According to EP 0 930 642, a plasma treatment apparatus for plasma-treating a substrate under a decompressed atmosphere comprises a chamber; an opening, formed in said chamber, for allowing the substrate to be conveyed into the chamber or taken out thereof; means for exhausting the chamber of gases; a lower electrode on which the substrate is placed; an upper electrode located inside the chamber and facing the lower electrode; gas supply means for supplying a treatment gas from the upper electrode toward the substrate placed on the lower electrode; a ring member located in the chamber and detachably fitted around the lower electrode; lift means for vertically moving the lower electrode together with the ring member; and a baffle plate fitted around the ring member, said baffle plate being moved to a position that is higher in level than an upper end of the opening of the chamber when the ring member is lifted by said lift means, the baffle plate at said position serving to shield a region near the opening of the chamber from a plasma generation region and also to allow reaction products which are produced by heat or plasma, to be adhered to the baffle plate, said baffle plate being also movable by said lift means to a position that is higher in level than a lower end of the opening of the chamber.

US 2003/029475 discloses a process for removing unwanted deposition build-up from one or more interior surfaces of a substrate processing chamber after depositing a layer of material over a substrate disposed in the chamber. In one embodiment the process comprises transferring the substrate out of the chamber; flowing a first gas into the substrate processing chamber and forming a plasma within the chamber from the first gas in order to heat the chamber; and thereafter, extinguishing the plasma, flowing an etchant gas into a remote plasma source, forming reactive species from the etchant gas and transporting the reactive species into the substrate processing chamber to etch the unwanted deposition build-up.

A need still exists in the art for improved plasma chamber clean. Remote plasma clean suffers from low efficiency due to high recombination rate of reactive species during the transfer from the remote plasma chamber to the processing chamber. On the other hand, state of the art in-situ plasma cleans are generally limited to chambers where plasma is used for the processing, i.e., excludes chambers such as CVD chambers. Moreover, the plasma apparatus conventionally used for in-situ clean is the same apparatus used for the processing of the substrate. Consequently, in general such apparatus is optimized for generating processing plasma, while leaving the cleaning plasma just as a side option.

The following summary of the invention is provided in order to provide a basic understanding of some aspects and features of the invention. This summary is not an extensive overview of the invention, and as such it is not intended to particularly identify key or critical elements of the invention, or to delineate the scope of the invention. Its sole purpose is to present some concepts of the invention in a simplified form as a prelude to the more detailed description that is presented below.

According to aspects of the invention, there is provided a novel in-situ plasma cleaning apparatus according to claim 1 and a method according to claim 13. Preferred embodiments of the invention are characterized in the sub-claims.

Various embodiments of the invention utilize the chamber body as part of the resonance cavity for generating the plasma in situ. Consequently, improved control of the plasma characteristics is enabled, while avoiding reactive species recombination.

According to aspects of the invention, a substrate processing chamber is provided, comprising: a chamber body having at least one plasma source opening provided on a sidewall thereof; a movable substrate holder situated within the chamber body, the substrate holder assuming a first position wherein the substrate is positioned below the plasma source opening, and a second position wherein the substrate is positioned above the plasma source opening; a plasma source coupled to the plasma source opening; a vacuum pump coupled to the chamber body to pump fluid therefrom; and a gas source couple to the chamber body to inject gas thereto. The plasma source opening may comprise a dielectric window and wherein the plasma source comprises a microwave source. The plasma source may comprise an RF energy source applying RF power to a coil wound about a tubular pipe, the tubular pipe being connected in fluid communication to the plasma source opening. The tubular pipe may comprise a dielectric pipe. The tubular pipe may comprise a conductor pipe having a dielectric break. The tubular pipe may be connected to the chamber body at two points opposing each other at 180 degrees.

According to aspects of the invention, a method for operating a substrate processing chamber having plasma energy source on a sidewall thereof for in-situ chamber cleaning is provided, comprising: loading a substrate onto a substrate holder situated in the chamber; raising the substrate holder to a level above the plasma energy source; processing the substrate; lowering the substrate holder to a level below the plasma energy source; unloading the substrate; activating the plasma energy source to ignite and maintain plasma within the chamber to perform in-situ chamber clean.

According to aspects of the invention, a method for operation the chamber, in a substrate processing chamber having variable processing cavity, is provided, comprising: placing the chamber in a first mode of operation by setting the variable cavity to a first volume; processing the substrate; placing the chamber in a second mode of operation by enlarging the variable cavity to assume a second volume larger than the first volume; striking and maintaining plasma within the variable cavity at its second volume to thereby perform in-situ cleaning of the variable cavity.

The accompanying drawings, which are incorporated in and constitute a part of this specification, exemplify the embodiments of the present invention and, together with the description, serve to explain and illustrate principles of the invention. The drawings are intended to illustrate major features of the exemplary embodiments in a diagrammatic manner. The drawings are not intended to depict every feature of actual embodiments nor relative dimensions of the depicted elements, and are not drawn to scale.

Figures 1A and 1B depict an example of a processing chamber according to an embodiment of the invention, wherein in Figure 1A the chamber is positioned for plasma cleaning, while in Figure 1B the chamber is positioned for processing.

Figures 2A and 2B illustrate another example of a processing chamber according to an embodiment of the invention, wherein in Figure 2A the chamber is positioned for plasma cleaning, while in Figure 2B the chamber is positioned for processing.

Figure 3 illustrates a process according to an embodiment of the invention.

Figures 4A and 4B illustrate another example of a processing chamber according to an embodiment of the invention, wherein in Figure 4A the chamber is positioned for plasma cleaning, while in Figure 4B the chamber is positioned for processing.

Figures 5A and 5B illustrate another example of a processing chamber according to an embodiment of the invention, wherein in Figure 5A the chamber is positioned for plasma cleaning, while in Figure 5B the chamber is positioned for processing.

Various embodiments of the invention are generally directed to plasma chamber clean, wherein the plasma is ignited and maintain in-situ, i.e., in the same cavity where processing takes place. The various embodiments described herein may be used, for example, in connection with various processing chambers used in fabricating semiconductor wafers, flat panel display, solar panels, etc. Among such processing chambers, the embodiments are suitable for use with, e.g., etch, CVD, PECVD, PVD, etc. Of course, the various embodiments and techniques described herein may have other applications not specifically mentioned herein.

In its conceptual implementation, the inventive chamber has two modes of operation with variable cavity. In the first mode of operation the cavity is set to a first volume for substrate processing, and in the second mode of operation the cavity is set to a second volume for in-situ cleaning. In the first mode of operation the substrate is processed and plasma may or may not be used. In the second mode of operation the cavity is enlarged and plasma is maintained for cleaning the chamber.

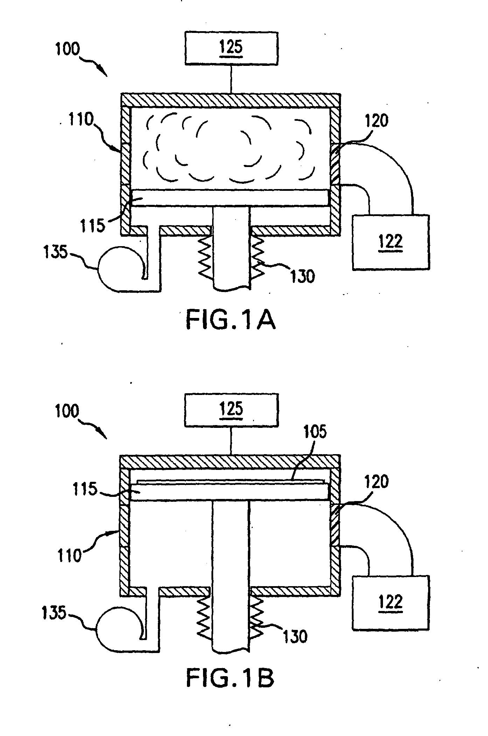

Figures 1A and 1B depict an example of a processing chamber according to an embodiment of the invention, wherein in Figure 1A the chamber is positioned for plasma cleaning, while in Figure 1B the chamber is positioned for processing. The processing chamber 100 may be, e.g., a CVD chamber for producing high purity thin firms on a substrate 105; however, as noted above, other chambers may employ the in-situ cleaning according to this embodiment. The substrate 105 is loaded into the chamber via load lock 110, and is placed on a substrate holder, such as chuck 115. Once the substrate 105 is placed on the chuck 115, the chuck is raised into processing position, shown in Figure 1B. Pump 135 is used to evacuate the chamber 100, while bellows 130 or other means may be used to enable movement of the chuck 115 without breaking the vacuum environment. The processing position places the substrate above the load lock 110 and above the dielectric window 120. Then, precursor gas from gas source 125 is introduced into the chamber to deposit the required layer on the substrate 105.

As is well known, during CVD processing, thin film is deposited on the substrate, and incidentally also deposited on the chamber walls. The deposition on the chamber wall needs to be removed, since otherwise it may flake off and contaminate subsequent wafers. Therefore, after the chuck 115 has been lowered and the wafer 105 removed from the chamber, the load lock 110 can be sealed and an in-situ plasma cleaning process may be carried on. According to this embodiment, inert and reactive gas, such as, e.g., Ar, He, NF3 (or any Flourine contained gases) etc., is introduced into the chamber under low pressure condition, e.g., lower than 1,33 Pa (10 Torr). Then, microwave energy from microwave source 122 is introduced into the chamber via dielectric window 120, to thereby strike and maintain plasma within the chamber. Depending on the requirements and the design, the microwave energy may assume various values, for example frequency of 2.45GHz at power range of 100W-10kW.

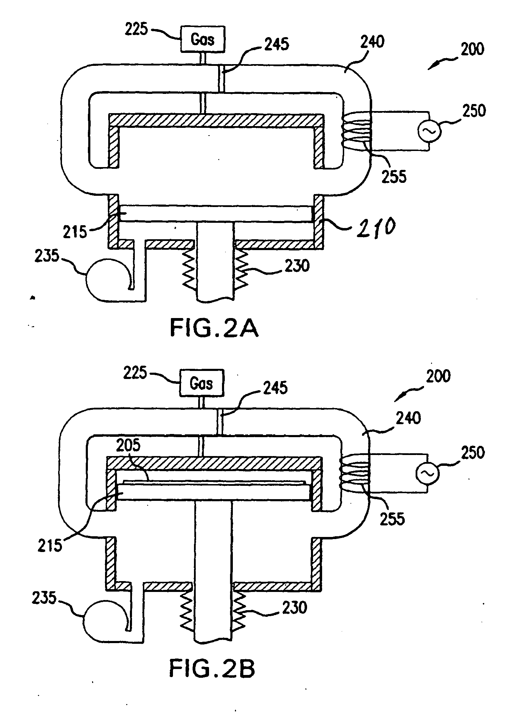

Figures 2A and 2B illustrate another example of a processing chamber according to an embodiment of the invention, wherein in Figure 2A the chamber is positioned for plasma cleaning, while in Figure 2B the chamber is positioned for processing. Elements in Figures 2A and 2B that are similar to those in Figures 1A and 1B are indicated by the same numerical references, except that they are in the 2xx series.

In Figure 2B, the chuck is raised into the processing position, and processing proceeds just like in the embodiment of Figure 1B. On the other hand, in Figure 2A the chuck is lowered for plasma cleaning operation. As with the embodiment of Figures 1A and 1B, in-situ plasma clean is performed in Figure 2A. However, in this embodiment rather than using a microwave energy, an RF energy is inductively coupled into a conduit 240 that is connected to the chamber. As shown in Figure 2A, a conduit 240 is connected to the chamber 200, forming a closed-circuit fluid communication with the variable cavity 202. In this example, the conduit 240 is connected to the chamber 200 at two points opposing each other at 180 degrees. The conduit 240 may be made of a dielectric material, or may be made of a conductive material, in which case it includes a dielectric break 245. RF energy from RF source 250 is inductively coupled into the conduit 240 via coil 255. Consequently, plasma is ignited in the closed-circuit fluid path that comprises the chamber's variable cavity 202 and conduit 240.

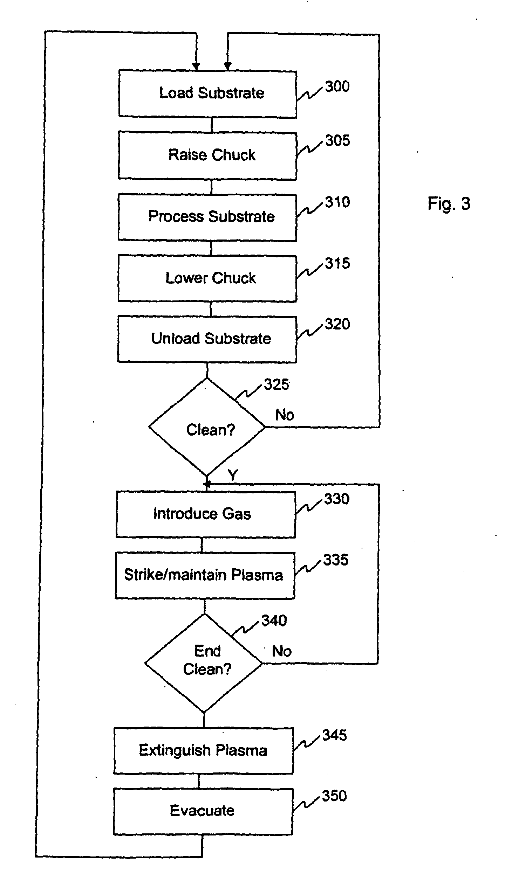

Figure 3 illustrates a process according to an embodiment of the invention. The process of Figure 3 may be implemented in any processing chamber constructed according to embodiment of the invention. In step 300 a substrate is loaded onto the substrate holder and the load lock is sealed. The chamber may be maintained in vacuum or low pressure condition. In step 305 the chuck is raised to its processing position, and in step 310 the substrate is processed. As noted above, processing the substrate may include etching, deposition, annealing, etc. Once processing is completed, at step 315 the chuck is lowered to its substrate unloading position and the substrate is unloaded at step 320.

At step 325 it is determined whether cleaning cycle is required. That is, under some conditions cleaning cycle may be performed after every processing cycle. However, under other situation cleaning may be performed after every n processing cycles, after T time has passed, by observing process results, etc. If no cleaning is required, the process proceeds to step 300. Otherwise, a cleaning cycle is started at step 330 by introducing cleaning gas, such a mixture of inert gas and active gas.

It should be noted at this point that the chuck may also be moved to a different position. That is, the chuck cleaning position may be different from the chuck substrate unloading position. Notably, for substrate unloading the chuck needs to clear the load lock. On the other hand, for cleaning cycle the chuck must clear the plasma energy source, such as the dielectric window, the opening of the conduit 240, etc. For simplicity, in the example of Figure 3 it is assumed that the substrate unloading and chamber cleaning positions are the same.

At step 335 the plasma source is energized to strike and maintain plasma in the chamber. At step 340 it is checked whether the end of the cleaning cycle is reached. This may be done by, e.g., using a timer or by analyzing the species that are being evacuated from the chamber. For example, when source gas, e.g., NF3, is used to generate fluorine radicals in order to clean silicon deposits from the chamber, the exhaust may be monitored for the presence of SiF4. As long as SiF4 is present in the evacuating gas, cleaning may continue by continuing to introduce gas and maintaining the plasma (steps 330 and 335). Absence of SiF4 signifies end of cleaning, and the process proceeds to step 345, where the plasma is extinguished. Optimally, the chamber may be pumped an additional period of time before reverting to step 300 to load the next substrate.

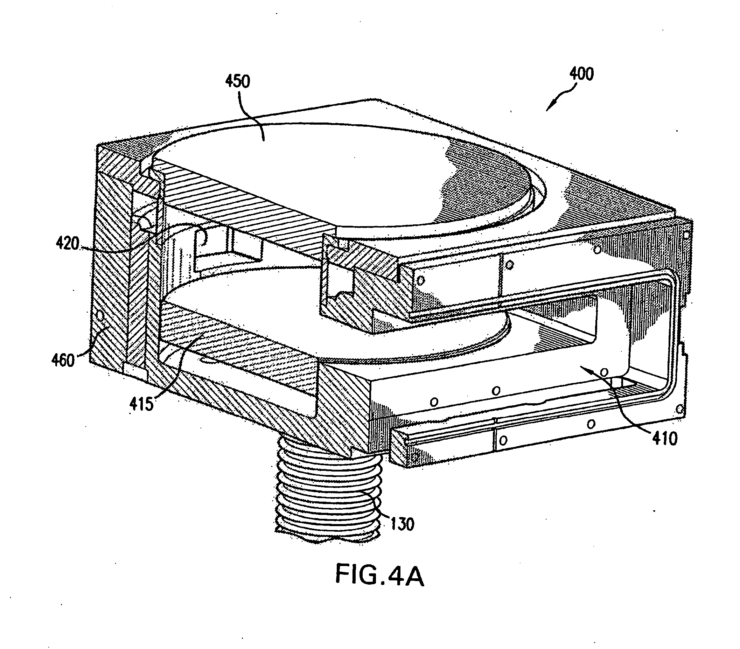

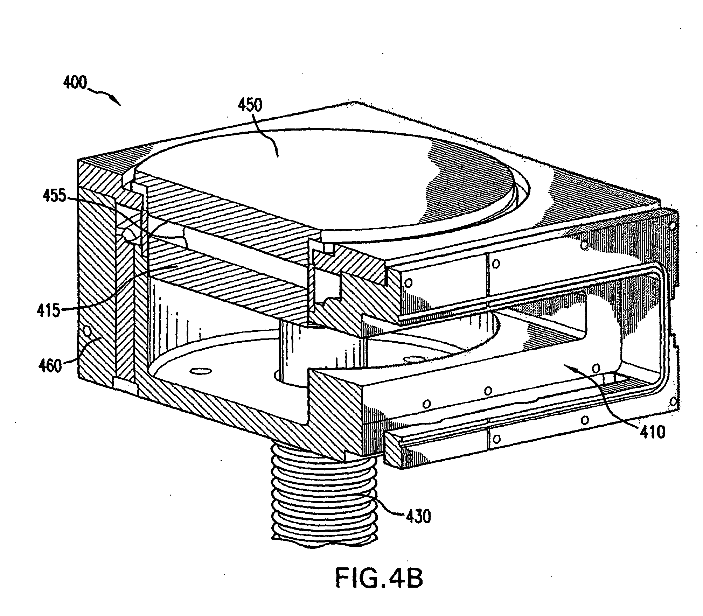

Figures 4A and 4B illustrate another example of a processing chamber according to an embodiment of the invention, wherein in Figure 4A the chamber is positioned for plasma cleaning, while in Figure 4B the chamber is positioned for processing. Elements in Figures 4A and 4B that are similar to those in Figures 1A and 1B are indicated by the same numerical references, except that they are in the 4xx series. Figures 4A and 4B are partial cross-section of 3-d model of the chamber. In this particular example, the chamber is normally used for CVD; however, other chambers may be used as well.

As shown in Figure 4A, the CVD chamber 400 of this embodiment has a chamber body 460 having internal cavity wherein a substrate can be processed. The substrate is loaded and unloaded from load lock opening 410, as is placed on substrate holder 415. In Figure 4A the substrate holder is shown in its lowered position, which allows for substrate loading and unloading, and also allows for chamber plasma cleaning operation. A showerhead 450 provides process gas and plasma cleaning gas. In this example, a plasma source opening 420 is provided on the sidewall of the chamber body 460. Here, the plasma source opening enables coupling of microwave energy into the cavity for striking and maintaining plasma for chamber cleaning operation.

In Figure 4B the substrate holder 415 assumes the upper position, which is utilized for substrate processing. Notably, when the substrate holder 415 assumes the processing position, the gap 455 is narrow, and the substrate clears, i.e., is above, the level of the plasma source opening 420 (not visible in Figure 4B, as it is being obscured by the substrate holder 415).

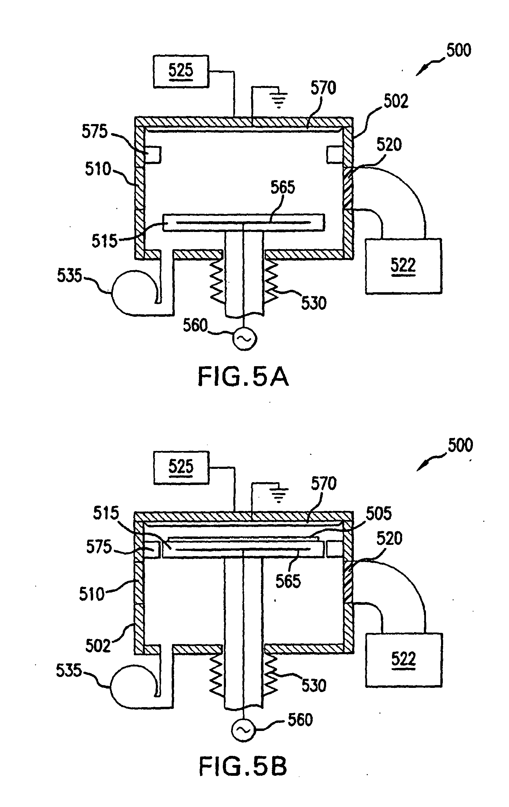

Figures 5A and 5B illustrate another example of a processing chamber according to an embodiment of the invention, wherein in Figure 5A the chamber is positioned for plasma cleaning, while in Figure 5B the chamber is positioned for processing. Elements in Figures 5A and 5B that are similar to those in Figures 1A and 1B are indicated by the same numerical references, except that they are in the 5xx series.

The chamber of Figures 5A and 5B includes two plasma sources, a capacitive RF coupling for plasma processing of the substrate and a microwave source for in-situ cleaning. For plasma processing of the substrate 505, RF energy from RF source 560 is coupled between a conductive electrode 565 embedded in the substrate support 515 and a conductive electrode 570 on the ceiling of the chamber. Here, the conductive electrode 570 is shown grounded while the conductive electrode 565 is shown connected to the hot side of the RF source 560, but it should be appreciated that the reverse is just as equally applicable. Also, while only one RF source is shown, it is known in the art to couple more than one RF sources, so as to couple more than one RF frequencies into the chamber. As is also known in the art, conductive electrode 570 may form part of a showerhead to inject gas from gas source 525 into the chamber.

When the chamber of Figures 5A and 5B is used for plasma processing, it may be used, e.g., to perform etch on the substrate. As is known, residency time of plasma species is an important factor in the quality of the etch process, which leads to enhanced requirement for pumping, i.e., chamber conductance. Therefore, in the chamber of Figures 5A and 5B the substrate holder 515 is made of a diameter smaller than the diameter of the chamber wall 502. Consequently, this configuration leaves much space between the edge of the substrate holder 515 and the chamber wall 502 for improved conductance. On the other hand, if the space is left open, plasma maintained for processing may travel below the substrate holder 505. To prevent that, a baffle 575 is situated at the level for substrate processing, as shown in Figure 5B. When the substrate holder is raised for processing, i.e., situation shown in Figure 5B, the substrate holder 515 is at the same level as the baffle 575, thereby presenting a closed space to the plasma. However, the baffle 575 includes holes of small size designed to enable gas pumping, but to appear as a barrier to the plasma.

On the other hand, when the substrate holder is positioned for in-situ cleaning, i.e., position shown in Figure 5A, the RF source 560 may be turned off, and microwave source 522 may be energized to ignite plasma for in situ cleaning of the chamber.

It should be understood that processes and techniques described herein are not inherently related to any particular apparatus and may be implemented by any suitable combination of components. Further, various types of general purpose devices may be used in accordance with the teachings described herein. It may also prove advantageous to construct specialized apparatus to perform the method steps described herein. The present invention has been described in relation to particular examples, which are intended in all respects to be illustrative rather than restrictive. Those skilled in the art will appreciate that many different combinations of hardware, software, and firmware will be suitable for practicing the present invention. For example, the described software may be implemented in a wide variety of programming or scripting languages, such as Assembler, C/C++, perl, shell, PHP, Java, HFSS, CST, EEKO, etc.

The present invention has been described in relation to particular examples, which are intended in all respects to be illustrative rather than restrictive. Those skilled in the art will appreciate that many different combinations of hardware, software, and firmware will be suitable for practicing the present invention. Moreover, other implementations of the invention will be apparent to those skilled in the art from consideration of the specification and practice of the invention disclosed herein. It is intended that the specification and examples be considered as exemplary only. The scope of the invention is defined by the following claims.

## Claims

1. A processing chamber having in-situ plasma clean capability, comprising:
a chamber body (100; 200; 400; 500) having a sidewall (110; 210; 410; 510);
a showerhead provided over the chamber body (100; 200; 400; 500);
a plasma energy source (122; 250; 522) coupled to the sidewall (110; 210; 410; 510) of the chamber body (100; 200; 400; 500); and
a movable substrate holder (115; 215; 415, 515) having an upper position for placing the substrate at a small gap below the showerhead while being above the plasma energy source (122; 250; 522), and a lower position below the plasma energy source (122; 250; 522).

2. The processing chamber of Claim 1, wherein the plasma energy source (122; 522) comprises a dielectric window (120; 520).

3. The processing chamber of Claim 2, wherein the plasma source comprises a microwave source (122).

4. The processing chamber of Claim 1, wherein the plasma energy source (250) comprises an RF energy source.

5. The processing chamber of Claim 1, wherein the plasma energy source (122; 522) comprises a tubular pipe coupled to the sidewall (110; 510).

6. The processing chamber of Claim 5, wherein the tubular pipe comprises a dielectric pipe.

7. The processing chamber according to Claim 1, wherein
the chamber body (100; 200; 400; 500) has at least one plasma source opening provided on a sidewall (110; 210; 410; 510) thereof;
the movable substrate holder (115; 215; 415, 515) is situated within the chamber body (100; 200; 400; 500) and configured to assume a first position wherein the substrate is positioned below the plasma source opening, and a second position wherein the substrate is positioned above the plasma source opening;
the plasma energy source (122; 250; 522) is coupled to the plasma source opening;
a vacuum pump (135; 235; 535) is coupled to the chamber body (100; 200; 400; 500) to pump fluid therefrom; and
a gas source (125; 225; 525) is coupled to the chamber body (100; 200; 400; 500) to inject gas thereto.

8. The processing chamber of Claim 7, wherein the plasma source opening comprises a dielectric window (120; 520) and wherein the plasma source comprises a microwave source (122).

9. The processing chamber of Claim 7, wherein the plasma source comprises an RF energy source applying RF power to a coil wound about a tubular pipe, the tubular pipe being connected in fluid communication to the plasma source opening.

10. The processing chamber of Claim 9, wherein the tubular pipe comprises a dielectric pipe.

11. The processing chamber of Claim 9, wherein the tubular pipe (240) comprises a conductor pipe having a dielectric break (245).

12. The processing chamber of Claim 5, wherein the tubular pipe (240) is connected to the chamber body (100; 500) at two points opposing each other at 180 degrees.

13. A method for operating a substrate processing chamber having a plasma energy source (122; 250; 522) on a sidewall (110; 210; 410; 510) thereof for in-situ chamber cleaning, comprising:
loading a substrate onto a substrate holder (115; 215; 415, 515) situated in the chamber;
raising the substrate holder (115; 215; 415, 515) to a processing level above the plasma energy source (122; 250; 522);
processing the substrate;
lowering the substrate holder (115; 215; 415, 515) to an unloading level below the plasma energy source (122; 250; 522);
unloading the substrate;
activating the plasma energy source (122; 250; 522) to ignite and maintain plasma within the chamber to perform in-situ chamber clean.

14. The method of claim 13, wherein, after unloading the substrate and before the cleaning, the substrate holder (115; 215; 415, 515) is moved to a cleaning level different from the unloading level but below the plasma energy source (122; 250; 522).

## Patentansprüche

1. Verarbeitungskammer mit der Fähigkeit zur In-situ-Plasmareinigung, welche folgendes umfasst:
einen Kammerkörper (100; 200; 400; 500) mit einer Seitenwand (110; 210; 410; 510);
einen über dem Kammerkörper (100; 200; 400; 500) vorgesehenen Duschkopf;
eine Plasmaenergiequelle (122; 250; 522), die mit der Seitenwand (110; 210; 410; 510) des Kammerkörpers (100; 200; 400; 500) verbunden ist; und
einen beweglichen Substrathalter (115; 215; 415, 515) mit einer oberen Stellung zum Anordnen des Substrats an einem kleinen Spalt unter dem Duschkopf während der sich über der Plasmaenergiequelle (122; 250; 522) befindet und einer unteren Stellung unter der Plasmaenergiequelle (122; 250; 522).

2. Verarbeitungskammer nach Anspruch 1, bei der die Plasmaenergiequelle (122; 522) ein dielektrisches Fenster (120; 520) umfasst.

3. Verarbeitungskammer nach Anspruch 2, bei der die Plasmaquelle eine Mikrowellenquelle (122) umfasst.

4. Verarbeitungskammer nach Anspruch 1, bei der die Plasmaenergiequelle (250) eine HF-Energiequelle umfasst.

5. Verarbeitungskammer nach Anspruch 1, bei der die Plasmaenergiequelle (122; 522) eine Rohrleitung umfasst, die an die Seitenwand (110; 510) gekoppelt ist.

6. Verarbeitungskammer nach Anspruch 5, bei der die Rohrleitung ein dielektrisches Rohr umfasst.

7. Verarbeitungskammer nach Anspruch 1, bei der:
der Kammerkörper (100; 200; 400; 500) zumindest eine Plasmaquellenöffnung umfasst, die an einer Seitenwand (110; 210; 410; 510) des Kammerkörpers vorgesehen ist;
der bewegliche Substrathalter (115; 215; 415, 515) im Inneren des Kammerkörpers (100; 200; 400; 500) angeordnet sowie derart konfiguriert ist, dass er eine erste Stellung, bei der das Substrat unter der Plasmaquellenöffnung positioniert wird, und eine zweite Stellung einnimmt,
bei der das Substrat über der Plasmaquellenöffnung positioniert wird;
die Plasmaenergiequelle (122; 250; 522) mit der Plasmaquellenöffnung gekoppelt ist;
eine Vakuumpumpe (135; 235; 535) mit dem Kammerkörper (100; 200; 400; 500) gekoppelt ist,
um Fluid aus diesem herauszupumpen; und
eine Gasquelle (125; 225; 525) mit dem Kammerkörper (100; 200; 400; 500) verbunden ist, um Gas in diesen einzuleiten.

8. Verarbeitungskammer nach Anspruch 7, bei der die Plasmaquellenöffnung ein dielektrisches Fenster (120; 520) umfasst, und bei der die Plasmaquelle eine Mikrowellenquelle (122) umfasst.

9. Verarbeitungskammer nach Anspruch 7, bei der die Plasmaquelle eine HF-Energiequelle umfasst, die HF-Strom an eine um eine Rohrleitung herum gewickelte Spule legt, wobei die Rohrleitung in Fluidverbindung mit der Plasmaquellenöffnung steht.

10. Verarbeitungskammer nach Anspruch 9, bei der die Rohrleitung ein dielektrisches Rohr umfasst.

11. Verarbeitungskammer nach Anspruch 9, bei der die Rohrleitung (240) ein Leitungsrohr mit einer dielektrischen Unterbrechung (245) umfasst.

12. Verarbeitungskammer nach Anspruch 5, bei der die Rohrleitung (240) an zwei einander 180° gegenüberliegenden Punkten mit dem Kammerkörper (100; 500) verbunden ist.

13. Verfahren zum Betrieb einer Substratverarbeitungskammer, die an einer Seitenwand (110; 210; 410; 510) eine Plasmaenergiequelle (122; 250; 522) zur In-situ-Reinigung der Kammer aufweist, mit folgenden Schritten:
Laden eines Substrats auf einen in der Kammer befindlichen Substrathalter (115; 215; 415, 515);
Hochfahren des Substrathalters (115; 215; 415, 515) auf ein Verarbeitungsniveau über der Plasmaenergiequelle (122; 250; 522);
Verarbeiten des Substrats;
Absenken des Substrathalters (115; 215; 415, 515) auf ein Entladeniveau unter der Plasmaenergiequelle (122; 250; 522);
Entladen des Substrats;
Aktivieren der Plasmaenergiequelle (122; 250; 522), um zur Durchführung einer In-situ-Reinigung der Kammer Plasma im Inneren der Kammer zu entzünden und zu halten.

14. Verfahren nach Anspruch 13, bei dem nach dem Entladen des Substrats und vor dem Reinigungsvorgang der Substrathalter (115; 215; 415, 515) auf ein Reinigungsniveau bewegt wird, das sich vom Entladeniveau unterscheidet, jedoch unter der Plasmaenergiequelle (122; 250; 522) liegt.

## Revendications

1. Une chambre de traitement ayant capacité de nettoyage par excitation de plasma in situ, comprenant:
- un corps de chambre (100; 200; 400; 500) ayant une paroi latérale (110; 210; 410; 510);
- une tête de douche pourvue sur le corps de chambre (100; 200; 400; 500);
- une source d'énergie de plasma (122; 250; 522) couplée à la paroi latérale (110; 210; 410; 510) du corps de chambre (100; 200; 400; 500); et
- un support de substrat mobile (115; 215; 415; 515) ayant une position supérieure pour placer le substrat à une petite ouverture sous la tête de douche pendant qu'étant au dessus de la source d'énergie de plasma (122; 250; 522), et une position inférieure sous la source d'énergie de plasma (122; 250; 522).

2. La chambre de traitement selon la revendication 1, où la source d'énergie de plasma (122, 522) comprend une fenêtre diélectrique (120; 520).

3. La chambre de traitement selon la revendication 2, où la source de plasma comprend une source de micro-ondes (122).

4. La chambre de traitement selon la revendication 1, où la source d'énergie de plasma (250) comprend une source d'énergie RF.

5. La chambre de traitement selon la revendication 1, où la source d'énergie de plasma (122, 522) comprend un conduit tubulaire couplé à la paroi latérale (110, 510).

6. La chambre de traitement selon la revendication 5, où le conduit tubulaire comprend un conduit diélectrique.

7. La chambre de traitement selon la revendication 1, où
- le corps de chambre (100; 200; 400; 500) présente au moins une ouverture de source de plasma pourvue sur une paroi latérale (110; 210; 410; 510) de celui-ci;
- le support de substrat mobile (115; 215; 415; 515) est situé dans le corps de chambre (100; 200; 400; 500) et configuré pour assumer une première position où le substrat est positionné sous l'ouverture de source de plasma, et une seconde position où le substrat est positionné au dessus de l'ouverture de source de plasma;
- la source d'énergie de plasma (122; 250; 522) est couplée à l'ouverture de source de plasma;
- une pompe de vide (135; 235; 535) est couplée au corps de chambre (100; 200; 400; 500) pour pomper le fluide de là; et
- une source de gaz (125; 225; 525) est couplée au corps de chambre (100; 200; 400; 500) pour y injecter le gaz.

8. La chambre de traitement selon la revendication 7, où l'ouverture de source de plasma comprend une fenêtre diélectrique (120; 520) et où la source de plasma comprend une source de micro-ondes (122).

9. La chambre de traitement selon la revendication 7, où la source de plasma comprend une source d'énergie RF appliquant la puissance RF à une bobine enroulée autour un conduit tubulaire, le conduit tubulaire étant connecté en communication par fluide à l'ouverture de source de plasma.

10. La chambre de traitement selon la revendication 9, où le conduit tubulaire comprend un conduit diélectrique.

11. La chambre de traitement selon la revendication 9, où le conduit tubulaire (240) comprend un conduit ayant un élément d'interruption diélectrique (245).

12. La chambre de traitement selon la revendication 5, où le conduit tubulaire (240) est connecté au corps de chambre (100; 500) à deux points s'opposant l'un à l'autre à 180 degrés.

13. Un procédé pour mettre en fonction une chambre de traitement de substrat ayant une source d'énergie de plasma (122; 250; 522) sur une paroi latérale (110; 210; 410; 510) de celle-ci pour le nettoyage de la chambre in situ, comprenant:
- charger un substrat sur un support de substrat (115; 215; 415; 515) situé dans la chambre,
- élever le support de substrat (115; 215; 415; 515) à un niveau de traitement au dessus de la source d'énergie de plasma (122; 250; 522);
- traiter le substrat;
- descendre le support de substrat (115; 215; 415; 515) à un niveau de déchargement sous la source d'énergie de plasma (122; 250; 522);
- décharger le substrat;
- activer la source d'énergie de plasma (122; 250; 522) pour allumer et maintenir le plasma dans la chambre pour réaliser le nettoyage de la chambre in-situ.

14. Le procédé selon la revendication 13, où, après le déchargement du substrat et avant le nettoyage, le support de substrat (115; 215; 415; 515) est déplacé à un niveau de nettoyage différent du niveau de déchargement mais sous la source d'énergie de plasma (122; 250; 522).
